# EUROPEAN PATENT SPECIFICATION

(11) **EP 3 007 110 B1**
(45) Date of publication and mention of the grant of the patent: **12.04.2017**
(21) Application number: 15188955.7
(22) Date of filing: 08.10.2015
(51) Int. Cl.: G06K 19/077, G06K 19/07

(54) **CABLE CONNECTION VERIFICATION SYSTEM, METHOD AND PROGRAM**
KABELVERBINDUNGSVERIFIKATIONSSYSTEM, VERFAHREN UND PROGRAMM
SYSTÈME, PROCÉDÉ ET PROGRAMME DE VÉRIFICATION DE CONNEXION DE CÂBLE

(30) Priority: 09.10.2014 JP 2014207992
(43) Date of publication of application: 13.04.2016
(73) Proprietor: Kabushiki Kaisha Toshiba, Minato-ku Tokyo 105-8001 (JP)
(72) Inventor: Nakajima, Takenobu, Minato-Ku, Tokyo 1058001 (JP)
(74) Representative: Moreland, David

(56) References cited:
- US-A1- 2010 210 135
- US-A1- 2013 300 539

## Description

### CROSS-REFERENCE TO RELATED APPLICATIONS

This application is based upon and claims the benefit of priority from Japanese Patient application No.2014-207992, filed on October 9, 2014, the entire contents of each of which are incorporated herein by reference.

### BACKGROUND

### Technical Field

Embodiments of the present invention relate to a cable connection verification technique for use in an operation of electrically cable-connecting contacts on terminal blocks spaced away from each other.

### Description of the Related Art

In field work and inspection at a power plant and the like, an operation of electrically connecting pieces of equipment by thousands of cables is carried out.

Such a cable connection verification operation is carried out by operators positioned at opposite ends of the cables. The operators locate the cables to be checked and test the cables using a circuit tester while communicating each other through voice communication devices.

When a detection value of the circuit tester matches a resistance value of the cable, continuity between contacts is verified and a drawing (connection diagram) is marked out, thereby leaving evidence of the operation.

Also, a technique is proposed which verifies cable connection by affixing tags from which ID information such as a two-dimensional code or RFID is extractable near contacts on terminal blocks or near cable terminals (see, for example, Japanese Patent Laid-Open No. 2009-273347).

The above-mentioned connection verification performed by extracting the ID information from the tags affixed to a cable or terminal blocks merely proves that cable terminals and terminal block contacts are combined and connected according to design specifications. Conventionally, for evidence which confirms the continuity of connected cables, a record of the connection diagrams marked out by operators is relied on giving low objectivity in proving continuity and giving rise to the possibility of human errors.

US 2010/0210135 discloses a communications system which includes a plurality of patch panels, wherein each patch panel has a plurality of connector ports on a front surface thereof that are each connected to a respective communication line, and one or more optical coupler/ connector ports on a rear surface thereof for linking two or more patch panels together. A cable for linking patch panels includes opposite ends and a respective connector at each end that is configured to be removably secured within a respective coupler/connector port on the rear surface.

US 2013/0300359 discloses methods, circuits, and system for automatically detecting connections between RFID tags. In one embodiment, a method is provided that includes periodically placing a charge on a node shared between a first RFID tag and a second RFID tag. The method also comprises sensing a voltage at the node at a time subsequent to the placing of the charge. The method also comprises automatically determining whether a connection exists between the first RFID tag and the second RFID tag based on the sensing of the voltage at the node. The first RFID tag and/or second RFID tag may include circuitry configured to perform the method.

### SUMMARY

Embodiments of the present invention have been implemented in view of the above circumstances and have an object to provide a cable connection verification technique capable of bearing out continuity between contacts on two terminal blocks coupled via terminals on opposite ends of cables, and thereby leaving evidence.

A cable connection verification system according to an embodiment of the present invention includes: a transmitter configured to transmit an inspection signal to a first terminal of a cable, the cable being configured to connect a first contact on a first terminal block with the first terminal and to connect a second contact on a second terminal block with a second terminal, wherein said inspection signal comprises information about respective registration codes of the to-be-verified contacts of the first terminal block and the second terminal block; a receiver configured to receive the inspection signal from the second terminal of the cable; a registration code processor configured to identify the registration codes in the received inspection signal; a tag generator configured to generate a tag containing ID information upon reception of the inspection signal at the receiver; and an information linking processor configured to link the ID information of the tag to the identified registration codes.

### BRIEF DESCRIPTION OF THE DRAWINGS

Fig. 1 is a block diagram showing a cable connection verification system according to a first embodiment of the present invention;
Fig. 2 is a block diagram showing a cable connection verification system according to a second embodiment of the present invention;
Fig. 3 is a block diagram showing a cable connection verification system according to a third embodiment of the present invention;
Fig. 4 is a block diagram showing a cable connection verification system according to a fourth embodiment of the present invention;
Fig. 5 is a table showing a list of registration codes;
Fig. 6 is a diagram showing a display screen of an inspection terminal or verification terminal; and
Fig. 7 is a flowchart describing operation of the cable connection verification systems according to embodiments.

### DETAILED DESCRIPTION OF THE PREFERRED EMBODIMENTS

### (First embodiment)

Embodiments of the present invention will be described below with reference to the accompanying drawings. The embodiments of the present invention provide a cable connection verification technique capable of bearing out continuity between contacts on two terminal blocks coupled via terminals on opposite ends of cables, and thereby leaving evidence.

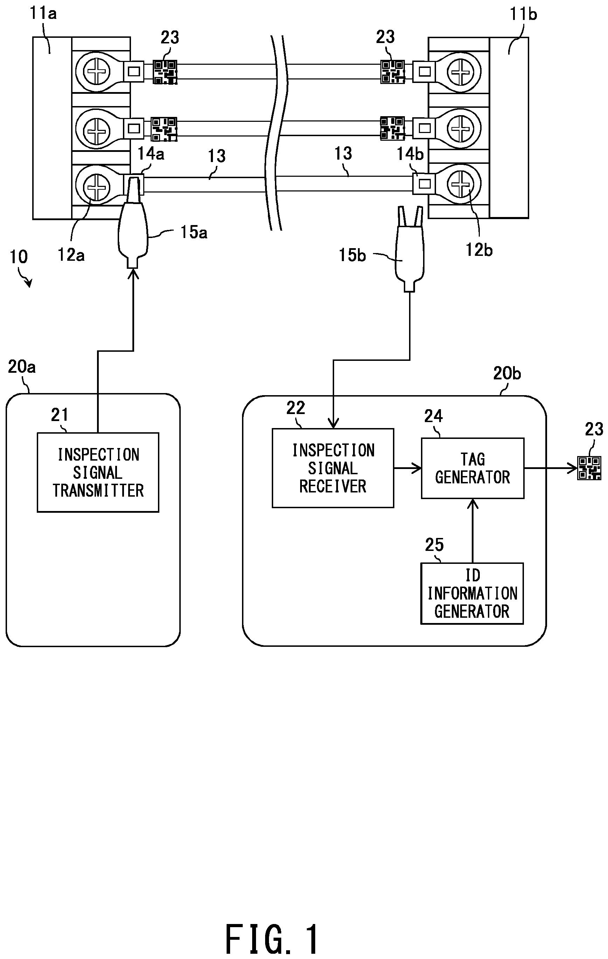

As shown in Fig. 1, a cable connection verification system 10 according to a first embodiment includes: an inspection signal transmitter 21 configured to transmit an inspection signal to a first terminal 14a of a cable 13 connecting a contact 12a on a first terminal block 11a and a contact 12b on a second terminal block 11b with each other; an inspection signal receiver 22 configured to receive the inspection signal from a second terminal 14b of the cable 13; and a tag generator 24 configured to generate a tag 23 containing ID information upon reception of the inspection signal.

Inspection signal transmitter 21, inspection signal receiver 22 and tag generator 24 may be realized with a central processing unit (CPU) includes an electronic circuit that can execute predetermined program codes. Inspection signal transmitter 21, inspection signal receiver 22 and tag generator 24 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing. Furthermore, tag generator 24 may be realized with a hardware such as a printer, a printer and its associated electronic circuit including but not limited to an IC, a CPU, an ASIC and/or an FPGA.

The terminal blocks 11 (11a and 11b) are provided on control devices (not shown) or a distribution board (not shown) of a plant.

Each of the terminal blocks 11 (11a and 11b) is provided with plural contacts 12 (12a or 12b), which are connected with cable terminals 14 (14a or 14b).

Note that in the embodiment, the cable terminal 14 and terminal blocks 11 are shown, by example, as being attached and detached via threaded fastening, but are not particularly limited thereto, and a one-touch lock type, for example, may be used alternatively.

Two operators each carrying an inspection terminal 20 (20a or 20b) are deployed on the sides of the terminals 14a and 14b of the cable 13, respectively.

The two operators are positioned at locations where they cannot talk to each other directly and are supposed to talk through voice communication devices. Each of the inspection terminals 20a and 20b may be provided with a voice communication function allowing the two operators to talk to each other using the inspection terminal 20a or 20b.

The inspection terminal 20a carried by one of the operators is connected with an alligator clip 15a detachably connected to the cable terminal 14a.

Through the alligator clip 15a, an analog current or voltage signal is sent as an inspection signal from the transmitter 21.

The inspection terminal 20b carried by another operator is connected with an alligator clip 15b detachably connected to the cable terminal 14b.

When the inspection signal is received by the receiver 22 through the alligator clip 15b, the tag generator 24 generates and prints a tag 23 containing ID information supplied from an ID information generator 25 or prints the ID information directly on the cable. The ID information, which is unique information including, for example, information about an identification symbol unique to a cable, an identification symbol unique to a terminal block, and an identification symbol unique to a control board, is intended to distinguish the cable from other cables.

ID information generator 25 may be realized with a central processing unit (CPU) includes an electronic circuit that can execute predetermined program codes. ID information generator 25 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

When attached to the tag 23 and printed by the tag generator 24 or its associated hardware, the ID information is converted into a two-dimensional code as illustrated. Besides the two-dimensional code, the ID information may be converted into a one-dimensional code, a hologram, other image information, a character string, or color information and may be included therein, but is not particularly limited thereto, and any medium may be used as long as the ID information, which is unique information, can be distinguished from other information.

While talking to each other through voice communication devices, the two operators attach the alligator clips 15 (15a and 15b) to the respective contacts 12 (12a and 12b) to be connected with the help of existing design information.

Then, if the cable 13 is connected correctly to the contacts 12 (12a and 12b) according to design information, a label-like tag 23 is genenrated, and affixed to the cable 13 near the terminal 14a to give evidence of the operation.

Now, the inspection terminals 20 (20a and 20b) connected to opposite ends of the cable 13 in the first embodiment have separate configurations, but a variation such as described below may be adopted.

That is, the opposite ends of the cable 13 are connected with inspection terminals (not shown) having a common configuration which incorporates all of the inspection signal transmitter 21, receiver 22, tag generator 24, and ID information generator 25.

Then, inspection signals may be transmitted alternately from opposite ends of the cable 13 and received at the other ends, followed by issuance of the tag 23.

Note that in the present embodiment, the tag 23 generated by the tag generator 24 and containing the ID information may be made of paper, film, or a plastic plate instead of a label. Furthermore, an electronic circuit such as a memory chip, RFID tag, or IC tag may be used as the tag 23. Alternatively, the tag 23 may be a paint, impression, or ink itself making up a character string, image, pattern, or color, which is to be painted, impressed, or printed directly on the cable 13.

### (Second embodiment)

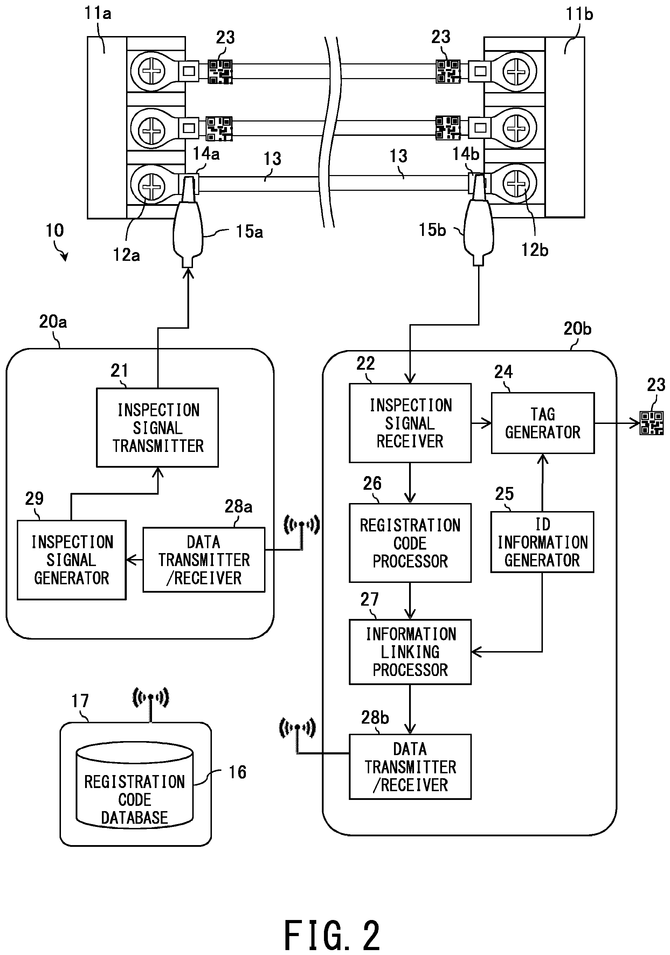

Next, a second embodiment will be described with reference to Fig. 2. In Fig. 2, components or functions in common with Fig. 1 are denoted by the same reference numerals as the corresponding components or functions in Fig. 1, and redundant description thereof will be omitted.

As shown in Fig. 2, in addition to the components shown in Fig. 1, a cable connection verification system 10 according to the second embodiment further includes a registration code database 16 configured to hold information about respective registration codes of the to-be-verified contacts 12a and 12b of the first terminal block 11a and second terminal block 11b, an registration code processor 26 configured to identify the registration codes in the inspection signal received by the receiver 22, and an information linking processor 27 configured to link the ID information of the tag 23 to the registration codes identified by the registration code processor 26.

Registration code processor 26 and linking processor 27 may be realized with a central processing unit (CPU) includes an electronic circuit that can execute predetermined program codes. Registration code processor 26 and linking processor 27 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

Registration code database 16 may be realized with a storage device, such as a semiconductor memory or a hard disk. Alternatively, registration code database 16 may be realized with an electronic circuit that executes predetermined program codes, such as a processor. Database 16 is not limited to software processing; registration code database 16 may be for example configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

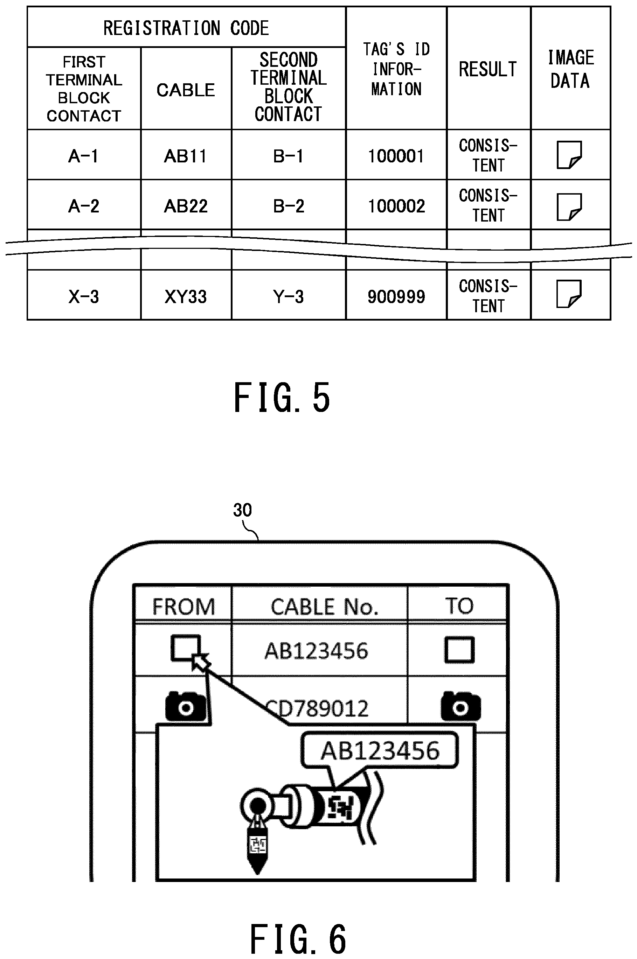

The registration codes, for example, are character symbols given beforehand as design information to identify the first terminal block contact 12a, cable 13, and second terminal block contact 12b as shown in Fig. 5.

The registration code database 16 (Fig. 2) holding the registration codes is installed in a management space 17 different from a field space which houses, for example, the terminal blocks 11 (11a and 11b) and the like.

Fig. 6 shows a display screen 30 in a display unit (not shown) of the inspection terminal 20.

A data transmitter/receiver 28a of the inspection terminal 20a (Fig. 2) acquires the registration codes (Fig. 5) of the contacts 12 from the registration code database 16 and displays the registration codes on the display screen 30. Data transmitter/receiver 28a may be an electronic circuit comprising an antenna and an IC or a processor capable of transmitting/receiving wireless signals such as radio waves, ultrasonic waves or optical signals. The processor of data transmitter/receiver 28b may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

On the display screen 30, for the registration codes of the cables 13, the registration codes of the first cable terminals 14a are listed in a FROM field and the registration codes of the second cable terminals 14b are listed in a TO field.

When a pair of terminals 14 (14a and 14b) to be inspected is specified on the display screen 30 (Fig. 6), an inspection signal generator 29 generates an inspection signal by encoding the registration codes of the cable terminals 14 (14a and 14b) and cable 13.

Inspection signal generator 29 may be realized with a central processing unit (CPU) includes an electronic circuit that can execute predetermined program codes. Inspection signal generator 29 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

The inspection signal generated in this way is a pulsed digital signal, and is transmitted to the first cable terminal 14a from the transmitter 21 and received by the receiver 22 connected to the second cable terminal 14b.

When the inspection signal is received by the receiver 22, the tag generator 24 generates and prints the tag 23 containing the ID information supplied by the ID information generator 25.

At the same time, the registration code processor 26 identifies the registration codes of the cable terminals 14 (14a and 14b) and cable 13 included in the inspection signal received by the receiver 22.

Then, the information linking processor 27 links the identified registration codes to the ID information supplied by the ID information generator 25.

The link results are transmitted to the registration code database 16 by the data transmitter/receiver 28b, and the registration codes of the contacts 12 (12a and 12b) and the ID information of the tag 23 are held by being associated with each other as shown in Fig. 5. Data transmitter/receiver 28b may be an electronic circuit comprising an antenna and an IC or a processor capable of transmitting/receiving wireless signals such as radio waves, ultrasonic waves or optical signals. The processor of data transmitter/receiver 28b may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

As a variation, opposite ends of the cable 13 may be connected with inspection terminals (not shown) having a common configuration which incorporates all of the inspection signal transmitter 21, inspection signal generator 29, receiver 22, tag generator 24, ID information generator 25, registration code processor 26, information linking processor 27, and data transmitter/receiver 28, and inspection signals may be transmitted alternately from the opposite ends of the cable 13 and received at the other ends, followed by issuance of the tag 23.

Thus, the second embodiment can leave evidence of a cable connection verification operation in conjunction with registration codes, which provide design information.

### (Third embodiment)

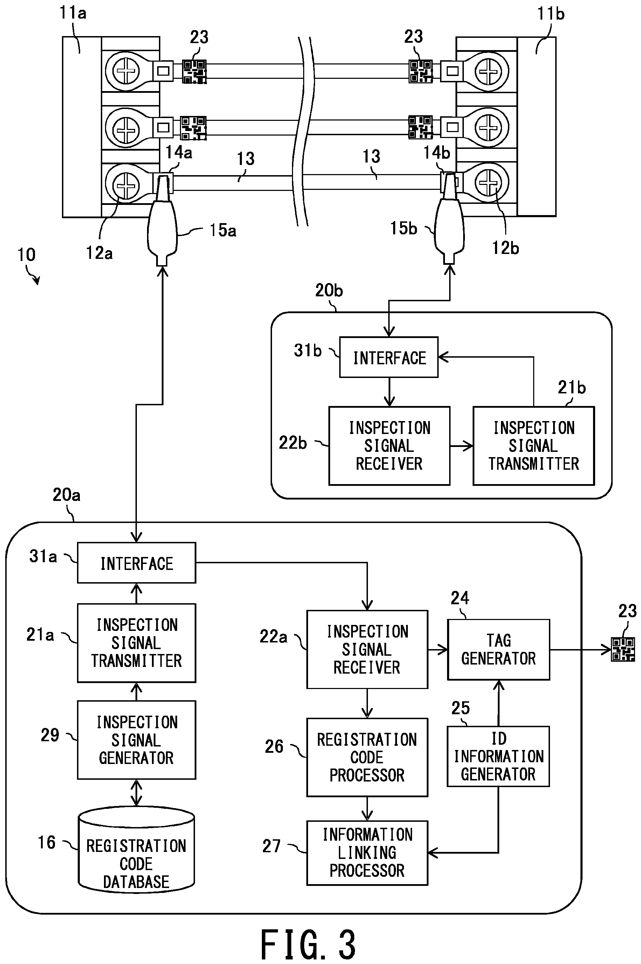

Next, a third embodiment will be described with reference to Fig. 3. In Fig. 3, components or functions in common with Fig. 1 are denoted by the same reference numerals as the corresponding components or functions in Fig. 1, and redundant description thereof will be omitted.

In a cable connection verification system 10 according to the third embodiment, the inspection terminal 20a connected to the first terminal 14a of the cable 13 includes a registration code database 16 configured to hold information about respective registration codes of the to-be-verified contacts 12a and 12b of the first terminal block 11a and second terminal block 11b, a generator 29 configured to generate an inspection signal by encoding the registration codes, a transmitter 21a configured to transmit the inspection signal to the first cable terminal 14a, a receiver 22a configured to receive the inspection signal returned from the second cable terminal 14b on the first cable terminal 14a, a tag generator 24 configured to generate a tag 23 containing ID information upon reception of the inspection signal, an registration code processor 26 configured to identify the registration codes in the inspection signal received by the receiver 22a, and an information linking processor 27 configured to link the ID information of the tag 23 to the registration codes identified by the registration code processor 26.

An interface 31a transmits the inspection signal transmitted from the transmitter 21a to the clip 15a and transmits the inspection signal transmitted from the inspection terminal 20b connected to the second cable terminal 14b, to the receiver 22a. Interface 31a may be realized with a circuit board comprising an input port, an output port and an electronic circuit, or a central processing unit (CPU) includes an electronic circuit that can execute predetermined program codes. Interface 31a may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

The inspection terminal 20b includes a receiver 22b configured to receive the inspection signal transmitted from the first cable terminal 14a on the second cable terminal 14b and a transmitter 21b configured to return the inspection signal to the first cable terminal 14a upon reception of the inspection signal by the receiver 22b.

An interface 31b transmits the inspection signal transmitted from the transmitter 21b to the clip 15b and transmits the inspection signal transmitted from the clip 15a to the receiver 22b. Interface 31b may be realized with a circuit board comprising an input port and an output port, or a central processing unit (CPU) includes an electronic circuit that can execute predetermined program codes. Interface 31b may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

Also, although not illustrated, the inspection terminal 20b may also be provided with a tag generator configured to generate and print a tag containing ID information upon reception of an inspection signal.

The registration code database 16 may be used for data communications by being installed externally instead of being installed in the inspection terminal 20a.

Thus, according to the third embodiment, by merely transmitting an inspection signal from the first terminal 14a, bidirectional signal propagation can be verified, making it possible to leave evidence of a cable connection verification operation.

### (Fourth embodiment)

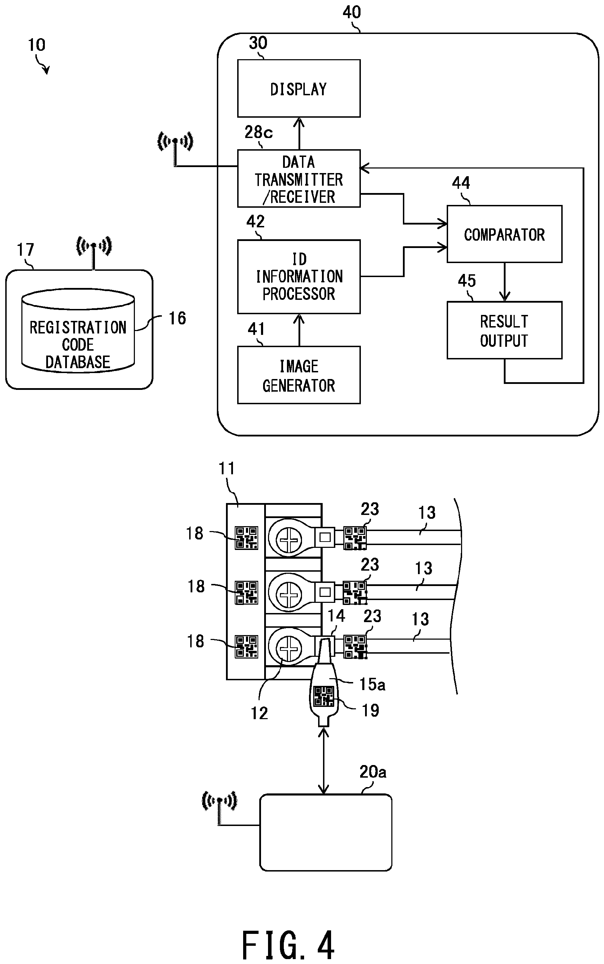

Next, a fourth embodiment will be described with reference to Fig. 4. In Fig. 4, components or functions in common with Fig. 1 are denoted by the same reference numerals as the corresponding components or functions in Fig. 1, and redundant description thereof will be omitted.

A cable connection verification system 10 according to the fourth embodiment is equipped with a verification terminal 40 which includes an image generator 41 configured to pick up image data of the tag 23 affixed near the cable terminal 14, an ID information processor 42 configured to extract ID information from the image data, and a comparator 44 configured to determine whether the ID information extracted from the image data is consistent or inconsistent with the ID information held in the registration code database 16 and linked to the registration code.

Image generator 41 may be realized with a camera including a semiconductor chip such as CCD or COMS, an optical unit such as a series of lens and a central processing unit (CPU) includes an electronic circuit that can execute predetermined program codes. The processing unit of image generator 41 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

ID information generator 42 may be realized with a central processing unit (CPU) includes an electronic circuit that can execute predetermined program codes. Image generator 41 and ID information generator 42 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

Note that according to the fourth embodiment, besides the tag 23 of the cable 13, a tag 18 associated with the registration code of the contact 12 is affixed to the terminal block 11.

It is assumed that the registration code of the contact 12 and ID information of the tag 18 are associated with each other in advance and held in the registration code database 16. Here, the tag 18 may be something printed on a label, paper, a plate, or film; or a code, a character string, an image, or color information painted, impressed, or printed directly on the terminal block 11. Also, using image information obtained by photographing the terminal block 11 as the tag 18, position of the contact 12 may be read by comparing the image information with image information about the terminal block 11 held in the registration code database 16 in advance by being associated with the registration code of the contact 12.

The ID information associated with the terminal block contact 12 and the ID information associated with the cable terminal 14 have been linked to each other through a process of the second embodiment or third embodiment.

The verification terminal 40 is suitably implemented by a portable tablet terminal equipped with a camera (image generator 41) as well as with a monitor (display unit 30) configured to display video, but is not particularly limited thereto. In the case of a tablet terminal, for example, the image generator 41 and display unit 30 may be provided on opposite planes.

The image generator 41 picks up image data of states of the tags 23 affixed to plural cables 13 and plural tags 18 affixed to the contacts 12 of the terminal block 11.

Then, the image data is additionally registered in a registration code table (Fig. 5) in the registration code database 16 via the communications unit 28c and allowed to be viewed on the display unit 30 (see Fig. 6), leaving evidence of a cable connection verification operation.

The processor 42 extracts ID information from the tags 18 and 23 which, being contained in the image data picked up, have a correspondence with each other, links the ID information, and transmits the ID information to the comparator 44.

Note that although in the embodiment, each terminal block contact 12 is identified using a tag 18, the terminal block contact 12 may be identified by positional information in image data using a feature point.

The data transmitter/receiver 28c acquires ID information about the terminal block contact 12 and the ID information about cable terminals 14, linked to each other, from the registration code database 16 and transmits the ID information to the comparator 44.

The comparator 44 determines whether the pair of linked pieces of ID information transmitted from the processor 42 and the pair of linked pieces of ID information transmitted from the communications unit 28c are consistent or inconsistent with each other.

Comparator 44 may be realized with a central processing unit (CPU) includes an electronic circuit that can execute predetermined program codes. Comparator 44 may be configured as a unit or a computer that is realized by hardware processing with the use of an electronic circuit such as ASIC (application specific integrated circuit) or FPGA (field-programmable gate array), or may be configured as a unit or a computer that is realized by a combination of software and hardware processing.

Then, a consistency/inconsistency result is displayed on the display unit 30 via an output 45 and additionally registered in the registration code table (Fig. 5) in the registration code database 16 via the communications unit 28c.

If an inconsistency result is displayed here, the operator is reminded that a tag 23 generated by the tag generator 24 has been erroneously affixed to a wrong cable 13.

Note that in the embodiment, the inspection terminal 20 (Figs. 2 and 3) and verification terminal 40 (Fig. 4) are configured to be separate members, but may be configured to be an integral member.

### (Fifth embodiment)

Furthermore, a fifth embodiment will be described with reference to Fig. 4.

According to the fifth embodiment, a tag 19 used to identify the inspection terminal 20 is affixed to the clip 15a connected to the terminal 14 to transmit an inspection signal to the cable 13.

Then, the processor 42 also extracts the ID information of the tag 19 affixed to the clip 15a from the image data picked up by the image generator 41.

The comparator 44 determines consistency/inconsistency of only a linked pair accompanied by the ID information of the tag 19 which identifies the clip 15a, and the display unit 30 displays a verification result.

Furthermore, at least one of the image generator 41, processor 42, and comparator 44 of the verification terminal 40 is configured to operate only during a period in which the tag 23 is generated and the transmitter 21a and receiver 22a (Fig. 3) are transmitting and receiving inspection signals.

Consequently, in a cable connection verification operation, since evidence is collected by keeping mechanical connections while inspection signals are being transmitted and received, it is possible to more securely prevent errors from getting mixed in the collected evidence.

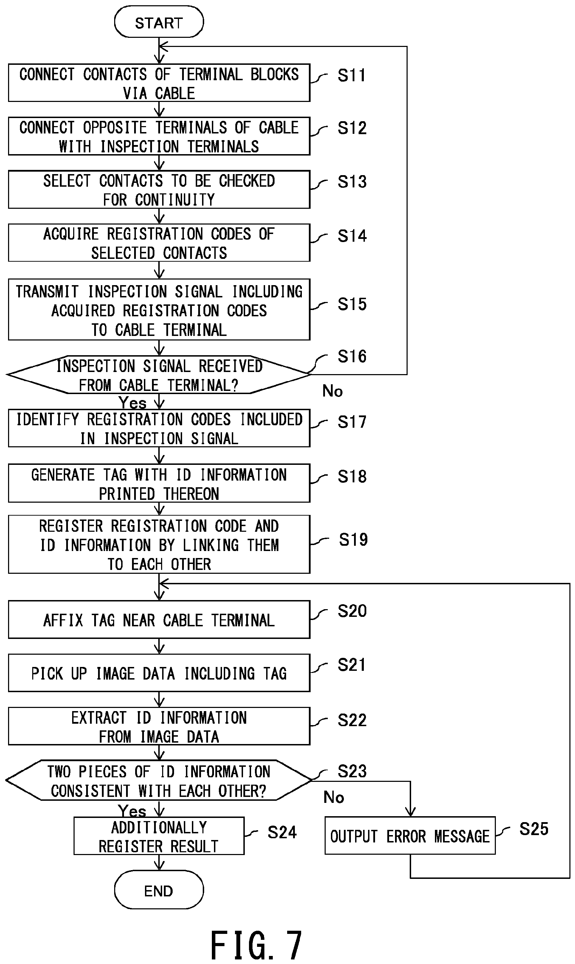

Now, operation of the cable connection verification systems according to the third and fourth embodiments will be described with reference to a flow chart of Fig. 7 (see Figs. 3 to 5 as appropriate).

During construction of a power plant, the contacts 12a and 12b of the terminal blocks 11 a and 11b are connected via the cable 13 (S11). The operator connects the two terminals 14a and 14b of the cable 13 with the inspection terminals 20a and 20b, respectively (S12).

By referring to a table (Fig. 5) displayed on the screen, the operator selects the contacts 12a and 12b to be checked for continuity and acquires corresponding registration codes from the registration code database 16 (S13 and S14).

An inspection signal including the acquired registration codes is generated by the generator 29 and transmitted to the cable terminal 14a by the transmitter 21a (S15).

When the inspection signal returned from the inspection terminal 20b connected to the second cable terminal 14b is received by the receiver 22a of the inspection terminal 20a connected to the first cable terminal 14a (S16: Yes), continuity between the contacts 12a and 12b is verified.

When continuity between the contacts 12a and 12b is not confirmed, cable connection is checked again (S16: No; S11).

On the inspection terminal 20a which has received the returned inspection signal, the registration code processor 26 identifies registration codes included in the inspection signal (S17), and the tag generator 24 generates and prints a tag 23 containing ID information (S18). The ID information of the tag 23 is registered by being linked to the registration codes in the registration code database 16 (S19).

On the other hand, the operator affixes the generated tag 23 near the cable terminal 14a (S20), starts up the verification terminal 40, and picks up image data including the identification tag 18 of the contact 12 and identification tag 23 of the cable terminal 14 (S21).

Then, by extracting ID information of the identification tag 18 of the contact 12 and ID information of the identification tag 23 of the cable terminal 14 from the image data (S22), it is determined whether the extracted ID information is consistent or inconsistent with the pair of linked pieces of ID information in the registration code database 16 (S23).

If a determination result indicates consistency (S23: Yes), the result is additionally registered together with the registration codes in the registration code database 16 and left as evidence (S24).

On the other hand, if the determination result indicates inconsistency, it is likely that the tag 23 has been affixed to a wrong cable 13, and an error message is outputted, promoting the operator to affix the tag anew (S23: No; S25, S20).

As the tag generated by verifying transmission and reception of inspection signals is affixed to the connected cable, the cable connection verification system according to at least one of the embodiments described above can bear out continuity between contacts on two terminal blocks and thereby leave evidence.

Whereas a few embodiments of the present invention have been described, these embodiments are presented only by way of example, and not intended to limit the scope of the invention as defined by the claims. These embodiments can be implemented in various other forms, and various omissions, replacements, changes, and combinations can be made without departing from the scope of the invention. Such embodiments and modifications thereof are included in the scope of the invention as well as in the invention set forth in the appended claims.

Also, the components of the cable connection verification system can be implemented by a computer processor and operated by a cable connection verification program.

## Claims

1. A cable connection verification system (10) comprising:
a transmitter (21) configured to transmit an inspection signal to a first terminal (14a) of a cable (13), the cable (13) being configured to connect a first contact (12a) on a first terminal block (11a) with the first terminal (14a) and to connect a second contact (12b) on a second terminal block (11b) with a second terminal (14b), wherein said inspection signal comprises information about respective registration codes of the to-be-verified contacts (12a, 12b) of the first terminal block (11a) and the second terminal block (11b);
a receiver (22) configured to receive the inspection signal from the second terminal (14b) of the cable (13);
a registration code processor (26) configured to identify the registration codes in the received inspection signal;
a tag generator (24) configured to generate a tag (23) containing ID information upon reception of the inspection signal at the receiver (22); and
an information linking processor (27) configured to link the ID information of the tag (23) to the identified registration codes.

2. The cable connection verification system (10) according to claim 1, wherein the receiver (22) receives the inspection signal returned from the second terminal (14b), on the first terminal (14a).

3. The cable connection verification system (10) according to claim 1, further comprising:
an image generator configured to pick up image data of the tag affixed to the first or the second terminal of the cable; and
an ID information processor configured to extract the ID information from the image data; and
a comparator configured to determine consistency of the ID information extracted from the image data and the ID information linked to the registration code.

4. The cable connection verification system according to claim 3, wherein to transmit the inspection signal, the ID information processor extracts at least one of ID information in an identification tag affixed to the first or the second terminal of the cable and ID information in identification tags affixed to the contacts.

5. The cable connection verification system according to claim 3, wherein at least one of the image generator, the ID information processor, and the comparator are configured to operate during a period in which the tag is generated and the transmitter and the receiver are transmitting and receiving the inspection signal.

6. A cable connection verification method comprising the steps of:
preparing a cable comprising a first terminal and a second terminal;
connecting the first terminal of the cable with a first contact on a first terminal block;
connecting the second terminal of the cable with a second contact on a second terminal block;
transmitting an inspection signal to the first terminal of the cable;
receiving the inspection signal from the second terminal of the cable, wherein the inspection signal comprises information about respective registration codes of the to-be-verified contacts of the first terminal block and second terminal block;
identifying the registration codes in the inspection signal;
issuing a tag containing ID information upon receiving the inspection signal; and
linking the ID information of the tag to the registration codes.

7. A cable connection verification program configured to cause a computer to execute the steps of:
transmitting an inspection signal to a first terminal of a cable, the cable being configured to connect a first contact on a first terminal block with the first terminal and to connect a second contact on a second terminal block with a second terminal, wherein the inspection signal comprises information about respective registration codes of the to-be-verified contacts of the first terminal block and second terminal block;
receiving the inspection signal from the second terminal of the cable;
identifying the registration codes in the inspection signal;
issuing a tag containing ID information upon receiving the inspection signal; and
linking the ID information of the tag to the registration codes.

## Patentansprüche

1. Kabelverbindungsverifikationssystem (10), aufweisend:
einen Sender (21), der konfiguriert ist, um ein Prüfsignal an einen ersten Anschluss (14a) eines Kabels (13) zu übertragen, wobei das Kabel (13) konfiguriert ist, um einen ersten Kontakt (12a) auf einer ersten Klemmenleiste (11a) mit dem ersten Anschluss (14a) zu verbinden und um einen zweiten Kontakt (12b) auf einer zweiten Klemmenleiste (11b) mit einem zweiten Anschluss (14b) zu verbinden, wobei das Prüfsignal Informationen über jeweilige Registrierungscodes der zu verifizierenden Kontakte (12a, 12b) der ersten Klemmenleiste (11a) und der zweiten Klemmenleiste (11b) aufweist;
einen Empfänger (22), der konfiguriert ist, um das Prüfsignal von dem zweiten Anschluss (14b) des Kabels (13) zu empfangen;
einen Registrierungscode-Prozessor (26), der konfiguriert ist, um die Registrierungscodes in dem empfangenen Prüfsignal zu identifizieren;
einen Tag-Generator (24), der konfiguriert ist, um ein Tag (23), das ID-Informationen enthält, nach Empfang des Prüfsignals an dem Empfänger (22) zu generieren; und
einen Informationenverknüpfungs-Prozessor (27), der konfiguriert ist, um die ID-Informationen des Tags (23) mit den identifizierten Registrierungscodes zu verknüpfen.

2. Kabelverbindungsverifikationssystem (10) nach Anspruch 1, wobei der Empfänger (22) das Prüfsignal, das von dem zweiten Anschluss (14b) zurückgesendet wird, an dem ersten Anschluss (14a) empfängt.

3. Kabelverbindungsverifikationssystem (10) nach Anspruch 1, ferner aufweisend:
einen Bildgenerator, der konfiguriert ist, um Bilddaten des Tags aufzunehmen, das an den ersten oder den zweiten Anschluss des Kabels angehängt ist; und
einen ID-Informationen-Prozessor, der konfiguriert ist, um die ID-Informationen aus den Bilddaten zu extrahieren; und
einen Komparator, der konfiguriert ist, um die Konsistenz der aus den Bilddaten extrahierten ID-Informationen und der mit dem Registrierungscode verknüpften ID-Informationen zu bestimmen.

4. Kabelverbindungsverifikationssystem nach Anspruch 3, wobei der ID-Informationen-Prozessor zum Übertragen des Prüfsignals mindestens eine von ID-Informationen in einem Identifizierungs-Tag extrahiert, das an den ersten oder den zweiten Anschluss des Kabels angehängt ist, und von ID-Informationen in Identifizierungs-Tags, die an die Kontakte angehängt sind.

5. Kabelverbindungsverifikationssystem nach Anspruch 3, wobei mindestens einer von dem Bildgenerator, dem ID-Informationen-Prozessor und dem Komparator konfiguriert ist, um während eines Zeitraums zu arbeiten, in dem das Tag generiert wird und der Sender und der Empfänger das Prüfsignal übertragen und empfangen.

6. Kabelverbindungsverifikationsverfahren, das folgende Schritte aufweist;
Vorbereiten eines Kabels, das einen ersten und einen zweiten Anschluss aufweist;
Verbinden des ersten Anschlusses des Kabels mit einem ersten Kontakt auf einer ersten Klemmenleiste;
Verbinden des zweiten Anschlusses des Kabels mit einem zweiten Kontakt auf einer zweiten Klemmenleiste;
Übertragen eines Prüfsignals an den ersten Anschluss des Kabels;
Empfangen des Prüfsignals von dem zweiten Anschluss des Kabels, wobei das Prüfsignal Informationen über jeweilige Registrierungscodes der zu verifizierenden Kontakte der ersten Klemmenleiste und der zweiten Klemmenleiste aufweist;
Identifizieren der Registrierungscodes in dem Prüfsignal;
Ausgeben eines Tags, das ID-Informationen enthält, nach Empfang des Prüfsignals; und
Verknüpfen der ID-Informationen des Tags mit den Registrierungscodes.

7. Kabelverbindungsverifikationsprogramm, das konfiguriert ist, um zu veranlassen, dass ein Computer die folgenden Schritte ausführt;
Übertragen eines Prüfsignals an einen ersten Anschluss eines Kabels, wobei das Kabel konfiguriert ist, um einen ersten Kontakt auf einer ersten Klemmenleiste mit dem ersten Anschluss zu verbinden und um einen zweiten Kontakt auf einer zweiten Klemmenleiste mit einem zweiten Anschluss zu verbinden, wobei das Prüfsignal Informationen über jeweilige Registrierungscodes der zu verifizierenden Kontakte der ersten Klemmenleiste und der zweiten Klemmenleiste aufweist;
Empfangen des Prüfsignals von dem zweiten Anschluss des Kabels;
Identifizieren der Registrierungscodes in dem Prüfsignal;
Ausgeben eines Tags, das ID-Informationen enthält, nach Empfangen des Prüfsignals; und
Verknüpfen der ID-Informationen des Tags mit den Registrierungscodes.

## Revendications

1. Système de vérification de connexion de câble (10) comprenant :
un émetteur (21) configuré pour émettre un signal d'inspection vers une première borne (14a) d'un câble (13), le câble (13) étant configuré pour connecter un premier contact (12a) sur un premier bloc de bornes (11a) à la première borne (14a) et pour connecter un deuxième contact (12b) sur un deuxième bloc de bornes (11b) à une deuxième borne (14b), dans lequel ledit signal d'inspection comprend des informations concernant les codes d'enregistrement respectifs des contacts à vérifier (12a, 12b) du premier bloc de bornes (11a) et du deuxième bloc de bornes (11b) ;
un récepteur (22) configuré pour recevoir le signal d'inspection à partir de la deuxième borne (14b) du câble (13) ;
un processeur de codes d'enregistrement (26) configuré pour identifier les codes d'enregistrement dans le signal d'inspection reçu ;
un générateur d'étiquettes (24) configuré pour générer une étiquette (23) contenant des informations d'identification après réception du signal d'inspection au niveau du récepteur (22) ; et
un processeur de liaison d'informations (27) configuré pour lier les informations d'identification de l'étiquette (23) aux codes d'enregistrement identifiés.

2. Système de vérification de connexion de câble (10) selon la revendication 1, dans lequel le récepteur (22) reçoit le signal d'inspection renvoyé à partir de la deuxième borne (14b), sur la première borne (14a).

3. Système de vérification de connexion de câble (10) selon la revendication 1, comprenant en outre :
un générateur d'images configuré pour capturer des données d'image de l'étiquette apposée à la première ou à la deuxième borne du câble ; et
un processeur d'informations d'identification configuré pour extraire les informations d'identification des données d'image ; et
un comparateur configuré pour déterminer une cohérence des informations d'identification extraites des données d'image et des informations d'identification liées au code d'enregistrement.

4. Système de vérification de connexion de câble selon la revendication 3, dans lequel, pour transmettre le signal d'inspection, le processeur d'informations d'identification extrait au moins l'une des informations d'identification dans une étiquette d'identification apposée à la première ou à la deuxième borne du câble et des informations d'identification dans les étiquettes d'identification apposées aux contacts.

5. Système de vérification de connexion de câble selon la revendication 3, dans lequel au moins l'un du générateur d'images, du processeur d'informations d'identification et du comparateur est configuré pour fonctionner pendant une période pendant laquelle l'étiquette est générée et pendant laquelle l'émetteur et le récepteur émet et reçoit le signal d'inspection.

6. Procédé de vérification de connexion de câble comprenant les étapes :
de préparation d'un câble comprenant une première borne et une deuxième borne ;
de connexion de la première borne du câble à un premier contact sur un premier bloc de bornes ;
de connexion de la deuxième borne du câble à un deuxième contact sur un deuxième bloc de bornes ;
d'émission d'un signal d'inspection vers la première borne du câble ;
de réception du signal d'inspection à partir de la deuxième borne du câble, dans lequel le signal d'inspection comprend des informations concernant les codes d'enregistrement respectifs des contacts à vérifier du premier bloc de bornes et du deuxième bloc de bornes ;
d'identification des codes d'enregistrement dans le signal d'inspection ;
d'émission d'une étiquette contenant des informations d'identification après réception du signal d'inspection ; et
de liaison des informations d'identification de l'étiquette et des codes d'enregistrement.

7. Programme de vérification de connexion de câble configuré pour amener un ordinateur à exécuter les étapes :
d'émission d'un signal d'inspection vers une première borne d'un câble, le câble étant configuré pour connecter un premier contact sur un premier bloc de bornes à la première borne et pour connecter un deuxième contact sur un deuxième bloc de bornes à une deuxième borne, dans lequel le signal d'inspection comprend des informations concernant les codes d'enregistrement respectifs des contacts à vérifier du premier bloc de bornes et du deuxième bloc de bornes ;
de réception du signal d'inspection à partir de la deuxième borne du câble ;
d'identification des codes d'enregistrement dans le signal d'inspection ;
d'émission d'une étiquette contenant des informations d'identification lors de la réception du signal d'inspection ; et
de liaison des informations d'identification de l'étiquette aux codes d'enregistrement.
